# EUROPEAN PATENT APPLICATION

(11) **EP 2 615 651 A1**
(43) Date of publication of application: **17.07.2013**
(21) Application number: 11823436.8
(22) Date of filing: 29.08.2011
(51) Int. Cl.: H01L 33/32, H01L 21/28, H01L 33/36

(54) **METHOD FOR PRODUCING GROUP III NITRIDE SEMICONDUCTOR LIGHT EMITTING ELEMENT AND GROUP III NITRIDE SEMICONDUCTOR LIGHT EMITTING ELEMENT**

(30) Priority: 08.09.2010 JP 2010201116
(71) Applicant: Sumitomo Electric Industries, Ltd., Chuo-ku Osaka-shi Osaka 541-0041 (JP)
(72) Inventor: YOSHIMOTO Susumu, Itami-shi Hyogo 664-0016 (JP); MITSUHASHI Fuminori, Itami-shi Hyogo 664-0016 (JP)
(74) Representative: Grünecker, Kinkeldey, Stockmair & Schwanhäusser
(86) International application number: PCT/JP2011/069488
(87) International publication number: WO 2012/032960

(57) **Abstract**

A group III nitride semiconductor light emitting device with a satisfactory ohmic contact is provided. The group III nitride semiconductor light emitting device includes a junction JC which tilts with respect to the reference plane that is orthogonal to a c-axis of a gallium nitride based semiconductor layer. An electrode forms the junction with the semipolar surface of the gallium nitride based semiconductor layer. The oxygen concentration of the grown gallium nitride based semiconductor layer that will form the junction JC is reduced. Since the electrode is in contact with the semipolar surface of the gallium nitride based semiconductor layer so as to form the junction, the metal-semiconductor junction has satisfactory ohmic characteristics.

## Description

### Technical Field

The present invention relates to a method for fabricating a group III nitride semiconductor light emitting device and to a group III nitride semiconductor light emitting device.

### Background Art

Patent Literature 1 describes a method for producing group III -V nitride semiconductors. The method can produce an ohmic electrode of low contact resistance with high reproducibility.

Non Patent Literature 1 describes an ohmic contact to p-type GaN. An alloy of Ni/Au is formed on the p-type GaN and is then annealed to transform metallic nickel into NiO along with amorphous Ni-Ga-O phase and large Au grains.

### Citation List

### Patent Literature

Patent Literature 1: Japanese Unexamined Patent Application Publication No. 2008-300421

### Non Patent Literature

Non Patent Literature 1: Jin-Kuo Ho et al., JOURNAL OF APPLIED PHYSICS, VOL. 86, No. 8, 1999, "Low-resistance ohmic contacts to p-type GaN achieved by the oxidation of Ni/Au films"

### Summary of Invention

### Technical Problem

An improved ohmic contact to a non-c-plane of a gallium nitride based semiconductor composed, such as gallium nitride, has been required. The finding by the inventors indicates that a non-c-plane, i.e., semipolar plane, of the gallium nitride based semiconductor composed, such as gallium nitride, is readily oxidized, compared to a c-plane, when the semiconductor is exposed to an atmosphere containing oxygen.

The finding suggests the importance of a decrease in the oxygen concentration at the surface of the gallium nitride based semiconductor which will form a junction with an electrode film. Unfortunately, oxygen is readily incorporated thereto during the production process. Another finding by the inventors indicates that cleavage of oxygen-gallium bonds on the semipolar surface cannot readily occur. It is believed that decrease in the oxygen concentration at the interface between the metal and the semiconductor depends on properties inherent to the semipolar surface of the gallium nitride based semiconductor layer.

It is an object of the present invention, which has been accomplished in view of such a circumstance, to provide a method for fabricating a group III nitride semiconductor light emitting device exhibiting a satisfactory ohmic contact. It is another object of the present invention to provide a group III nitride semiconductor light emitting device with a satisfactory ohmic contact.

### [Solution to Problem]

One aspect in accordance with the present invention provides a method for fabricating a group III nitride semiconductor light emitting device. The method comprises: (a) exposing an epitaxial substrate to a gallium atmosphere in a vacuum chamber at a substrate temperature of 300 degrees Celsius or higher without growing group III nitride semiconductor, and (b) growing a conductive layer for an electrode on a primary surface of the epitaxial substrate in the vacuum chamber to provide a substrate product. The primary surface of the epitaxial substrate is composed of a gallium nitride based semiconductor to exhibit semi-polarity. The epitaxial substrate includes an active layer composed of a group III nitride semiconductor.

According to the fabrication method, the epitaxial substrate is exposed to a gallium atmosphere in a vacuum chamber at a substrate temperature of 300 degrees Celsius or higher without the growth of the group III nitride semiconductor. Although the surface of the group III nitride semiconductor of the epitaxial substrate is covered with an oxide layer before the exposing step, the exposing step supplies gallium to the semipolar primary surface of the gallium nitride based semiconductor so that the gallium oxide formed on the semipolar primary surface is transformed into gallium oxide of a low melting point to decrease the amount of gallium oxide. This chemical reaction is expressed as follows:

Ga₂O₃ + 4Ga ⇒3Ga₂O

The digallium oxide Ga₂O is released from gallium nitride based semiconductor into the vacuum chamber by the action of the substrate temperature in the exposing step depending on its melting point. In other words, gallium irradiation of the semipolar primary surface, which is readily oxidized with oxygen, can reduce the amount of the oxygen concentration around the semipolar primary surface before the electrode layer forms a junction with the semipolar primary surface. Accordingly, the resulting group III nitride semiconductor light emitting device exhibits a satisfactory ohmic contact.

The production method according to the aspect of the present invention may further comprise the step of forming a semiconductor region on the primary surface of the substrate to provide the epitaxial substrate. The primary surface of the substrate comprises a group III nitride semiconductor. The semiconductor region includes a group III nitride semiconductor layer of a first conductivity type, the active layer, and a group III nitride semiconductor layer of a second conductivity type. The epitaxial substrate includes the substrate, the primary surface of the substrate preferably tilting at an angle of the range of 10 degrees to 80 degrees with respect to the plane that is orthogonal to a reference axis extending along the c-axis of the group III nitride semiconductor, and the primary surface of the epitaxial substrate preferably tilting at an angle within the range of 10 degrees to 80 degrees with respect to the plane that is orthogonal to a reference axis extending along the c-axis of the group III nitride semiconductor.

According to the fabrication method, the semipolar surface of the gallium nitride based semiconductor tilting at an angle within the range of 10 degrees to 80 degrees is readily oxidized with oxygen. This indicates the importance of decrease in oxygen in the formation of an ohmic electrode.

In the fabrication method according to the aspect of the present invention, the epitaxial substrate may include a p-type gallium nitride based semiconductor layer grown on the active layer, the p-type gallium nitride based semiconductor layer preferably includes magnesium as a dopant, and the primary surface of the p-type gallium nitride based semiconductor layer preferably corresponds to the primary surface of the epitaxial substrate.

According to the fabrication method, an electrode providing an ohmic contact can be formed on a p-type gallium nitride based semiconductor layer.

In the fabrication method according to the aspect of the present invention, the conductive layer preferably comprises any one of Au, Pd, Ni, Rh, Al, Ti, Zn, Cu, In, Ta, Pt, and Tl. In the production method, the conductive layer preferably contains at least one of Au, Pd, Ni, Rh, Al, Ti, Zn, Cu, In, Ta, Pt, and T1.

In the fabrication method according to the aspect of the present invention, the substrate temperature is preferably equal to or lower than the lowest temperature used during the growth of the epitaxial substrate. According to the fabrication method, possible thermal stress applied to the active layer during the exposing step can be decreased.

In the fabrication according to the aspect of the present invention, the lowest temperature is preferably 900 degrees Celsius or lower. According to the fabrication method, decrease in the oxygen concentration around the semipolar primary surface can be achieved by utilizing gallium oxides which have different melting points. The gallium oxides includes, for example, Ga₂O₃ having a relatively high melting point (for example, 1725 degrees Celsius, 1 atmospheric pressure, room temperature), and Ga₂O having a relatively low melting point (for example, 500 degrees Celsius, 1 × 10⁻⁶ Torr).

In the fabrication method according to the aspect of the present invention, the active layer may include an InGaN layer, and the substrate temperature of the epitaxial substrate is preferably equal to or lower than the growth temperature of the InGaN layer of the active layer. The fabrication method can avoid deterioration in the quality of the InGaN layer of the active layer, which is caused by annealing in the exposing step.

The fabrication method according to the aspect of the present invention may further comprises the step of carrying out patterning to form the electrode after the substrate product is taken out of the vacuum chamber. The method preferably does not involve alloying of the electrode after the growth of the conductive layer. According to this fabrication method, the step of alloying the electrode may be omitted.

In the fabrication method according to the aspect of the present invention, the group III nitride semiconductor of the substrate preferably comprises GaN. Additionally, in the fabrication method according to the aspect of the present invention, the primary surface of the epitaxial substrate is preferably composed of GaN.

The fabrication method according to the aspect of the present invention may further comprises the step of growing a group III nitride semiconductor on the active layer after providing the vacuum chamber with the epitaxial substrate. According to the fabrication method, the oxygen concentration of the group III nitride semiconductor grown through the film formation can be decreased.

In the fabrication method according to the aspect of the present invention, after exposing the epitaxial substrate to gallium atmosphere, the conductive layer is grown without growing group III nitride semiconductor. According to the fabrication method, an ohmic electrode can be formed on the modified semipolar plane.

In the fabrication method according to the aspect of the present invention, the primary surface of the epitaxial substrate preferably tilts at an angle in the range of 63 degrees to 80 degrees with respect to the plane that is orthogonal to the reference axis extending along the c-axis of the group III nitride semiconductor. The semipolar surface tilting within such an angle range has steps which are readily oxidized.

In the fabrication method according to the aspect of the present invention, the oxygen concentration in the gallium nitride based semiconductor layer in contact with the conductive layer may be 1 × 10¹⁸cm⁻³ or lower. According to the fabrication method, the oxygen concentration of the gallium nitride based semiconductor region that will form a junction with the electrode can be decreased.

A group III nitride semiconductor light emitting device according to another aspect of the present invention includes (a) a group III nitride semiconductor layer of a first conductivity type, (b) an active layer grown on the primary surface of the group III nitride semiconductor layer of a first conductivity type, (c) a group III nitride semiconductor layer grown on the primary surface of the active layer, and (d) an electrode forming a junction with the group III nitride semiconductor layer. The group III nitride semiconductor layer is of a second conductivity type. The junction is inclined with respect to the reference plane that is orthogonal to the c-axis of the group III nitride semiconductor layer of a first conductivity type.

The group III nitride semiconductor light emitting device has the junction, which tilts with respect to the reference plane that is orthogonal to the c-axis of the group III nitride semiconductor layer of a first conductivity type, and accordingly the electrode forms a junction with the semipolar surface of the group III nitride semiconductor layer of the second conductivity type. The junction between the semipolar surface and the electrode has satisfactory ohmic characteristics.

In the group III nitride semiconductor light emitting device according to the other aspect of the present invention, the junction may tilt at an angle in the range of 10 degrees to 80 degrees from the plane that is orthogonal to the reference axis. According to the group III nitride semiconductor light emitting device, the semipolar surface tilting at the angle in the range of 10 degrees to 80 degrees is readily oxidized compared to the c-plane (polar plane); hence, this aspect is preferred.

In the group III nitride semiconductor light emitting device according to the other aspect of the present invention, the electrode may comprise any one of Au, Pd, Ni, Rh, Al, Ti, Zn, Cu, In, Ta, Pt, and Tl. The group III nitride semiconductor light emitting device is preferably composed of at least one of Au, Pd, Ni, Rh, Al, Ti, Zn, Cu, In, Ta, Pt, and Tl.

The group III nitride semiconductor light emitting device according to the other aspect of the present invention may further include a support base having a primary surface composed of a group III nitride semiconductor. The primary surface of the support base tilts at an angle in the range of 10 degrees to 80 degrees from the plane orthogonal to the reference axis extending along the c-axis of the group III nitride semiconductor. The group III nitride semiconductor layer of a first conductivity type, the active layer, and the group III nitride semiconductor layer are aligned along the normal to the primary surface of the support base.

The group III nitride semiconductor light emitting device can provide a satisfactory ohmic contact with the semipolar top surface of the semiconductor laminate that includes semiconductor layers deposited in sequence on the semipolar surface which tilts within an angle range from 10 degrees to 80 degrees.

In the group III nitride semiconductor light emitting device according to the other aspect of the present invention, the support base includes the group III nitride semiconductor preferably comprising GaN. Additionally, in the group III nitride semiconductor light emitting device according to the other aspect of the present invention, the primary surface of the group III nitride semiconductor layer is preferably composed of GaN.

In the group III nitride semiconductor light emitting device according to the other aspect of the present invention, the active layer includes a gallium nitride based semiconductor layer containing indium as a group III constituent element, and the active layer is configured to provide a peak emission wavelength within the wavelength range, for example, of 360 nm to 600 nm.

The group III nitride semiconductor light emitting device can reduce the drive voltage in a wavelength range of 360 nm to 600 nm.

The above-described object and other objects, features, and advantages of the present invention will be readily apparent also from the following detailed descriptions of the preferable embodiment of the present invention with reference to the accompanying drawings.

### Advantageous Effects of Invention

As described above, the aspect of the present invention provides a method for fabricating a group III nitride semiconductor light emitting device exhibiting a satisfactory ohmic contact. The other aspect of the present invention provides a group III nitride semiconductor light emitting device exhibiting a satisfactory ohmic contact.

### Brief Description of Drawings

Fig. 1 is a schematic diagram illustrating major steps of a method for fabricating a group III nitride semiconductor light emitting device according to an embodiment of the present invention;
Fig. 2 is a schematic diagram illustrating major steps of the method for fabricating the group III nitride semiconductor light emitting device according to an embodiment of the present invention;
Fig. 3 is a schematic diagram illustrating major steps of the method for fabricating the group III nitride semiconductor light emitting device according to an embodiment of the present invention;
Fig. 4 is a schematic diagram illustrating major steps of the method for fabricating the group III nitride semiconductor light emitting device according to an embodiment of the present invention;
Fig. 5 is a view showing a transmission electron microscopic (TEM) image around an interface between a GaN region and metal (gold);
Fig. 6 is a graph representing the oxygen concentration of a gallium nitride based semiconductor region, measured with secondary ion mass spectroscopic (SIMS) analysis, of a base layer for an electrode; and
Fig. 7 is a graph representing current-voltage characteristics.

### Description of Embodiments

The teachings of the present invention can be readily apparent from the following detailed descriptions with reference to the accompanying drawings that illustrate typical embodiments. The method for producing a group III nitride semiconductor light emitting device, and the group III nitride semiconductor light emitting device according embodiments of the present invention will now be described with reference to the accompanying drawings. The same reference symbols are assigned to the same portion, when possible.

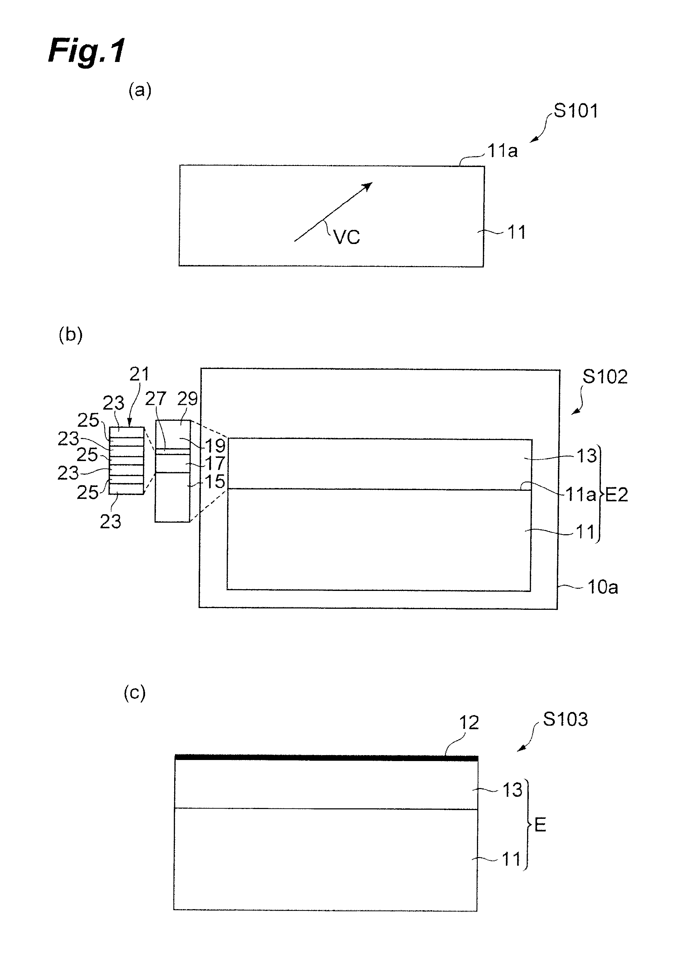

Figs. 1 to 4 are schematic diagrams illustrating major steps of the method for fabricating a group III nitride semiconductor light emitting device according to an embodiment of the present invention. As shown in Part (a) of Fig. 1, a substrate 11 is prepared in step S101. The substrate 11 has a primary surface 11a comprising a group III nitride semiconductor. The primary surface 11a tilts away from a plane orthogonal to the reference axis (shown by a vector VC) that extends in the direction of the c-axis of the group III nitride semiconductor, and accordingly exhibits semi-polarity. The group III nitride semiconductor of the substrate 11 may be composed of, for example, GaN.

As shown in Part (b) of Fig. 1, in step S102, a semiconductor stack 13 for a semiconductor light emitting device is grown on the substrate 11 in a reactor 10a to form an epitaxial substrate E. The embodiment will be further described below. After placing the substrate in the reactor 10a, gas containing ammonia and hydrogen is supplied into the reactor 10a to carry out thermal cleaning of the primary surface 11a of the substrate 11. Plural group III nitride semiconductor layers are then grown on the primary surface 11a of the substrate 11 in sequence in the reactor 10a. The epitaxial method performed in the reactor 10a may be, for example, organometallic vapor phase epitaxy.

The semiconductor stack 13 includes a first conductivity type group III nitride semiconductor layer such as an n-type group III nitride semiconductor region 15, an active layer 17, and a second conductivity type group III nitride semiconductor such as a p-type group III nitride semiconductor region 19. The n-type group III nitride semiconductor region 15 may comprise, for example, GaN, AlGaN, or InAlGaN. The p-type group III nitride semiconductor region 19 may comprise, for example, GaN, AlGaN, or InAlGaN, and may include an electron blocking layer 27 and a p-type cladding layer 29. The p-type group III nitride semiconductor region 19 may include a p-type contact layer if needed. The active layer 17 has, for example, a quantum well structure 21 comprising barrier layers 23 and well layers 25, which are alternately arranged. The band gap of the barrier layers 23 is greater than that of the well layers 25. The barrier layers 23 may be composed of, for example, GaN, InGaN, or InAlGaN. The well layers 25 may be composed of, for example, GaN, InGaN, or InAlGaN.

In step S102, the semiconductor stack 13 is grown on the primary surface 11 a of the substrate 11 to form an epitaxial substrate, and the primary surface 11a of the substrate 11 preferably tilts at an angle ranging from 10 degrees to 80 degrees with respect to a plane orthogonal to the reference axis Cx that extends along the c-axis of the group III nitride semiconductor. The primary surface of the epitaxial substrate E also preferably tilts at an angle with the range of from 10 degrees to 80 degrees with respect to the plane orthogonal to the reference axis Cx, and accordingly the semipolar surface of the gallium nitride based semiconductor is readily oxidized with oxygen at a tilt angle ranging from 10 degrees to 80 degrees of these primary surfaces. Accordingly, it is important to decrease oxygen during the formation of an ohmic electrode.

The primary surface of the epitaxial substrate E preferably tilts at an angle within the range of 63 degrees to 80 degrees away from a plane orthogonal to the reference axis that extends along the c-axis of the group III nitride semiconductor. The semipolar surface tilting within the above angle range has steps which are readily oxidized.

As illustrated in Part (c) of Fig. 1, in step S103, the epitaxial substrate E is removed from the reactor 10a, so that the epitaxial substrate E removed is exposed to an atmosphere containing oxygen. As a result, native gallium oxide 12 is formed on the surface of the epitaxial substrate exposed thereto, i.e., the surface of the gallium nitride based semiconductor.

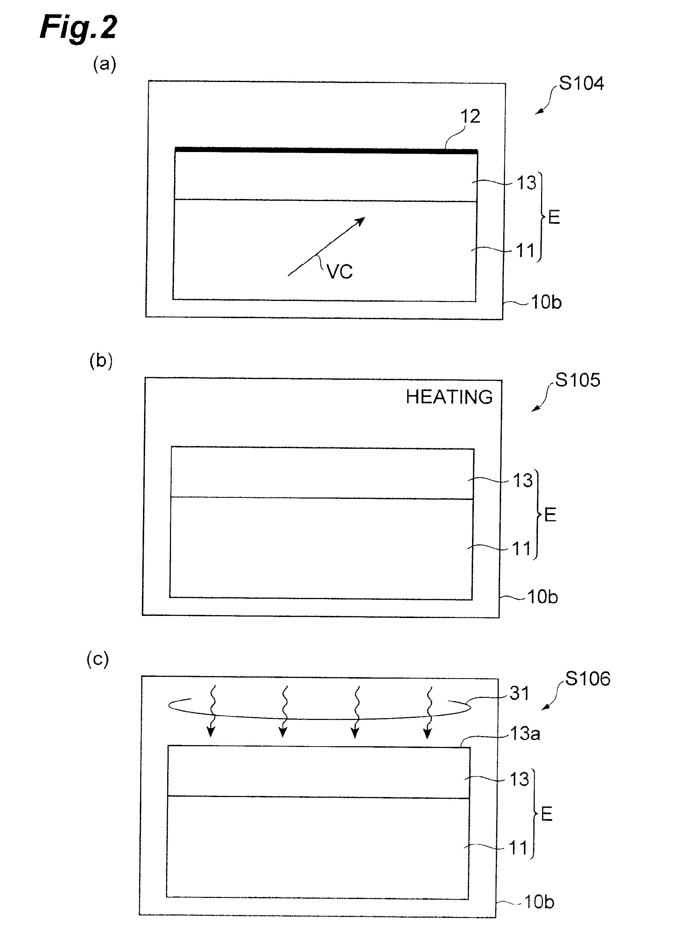

The epitaxial substrate E is taken out of the reactor 10a, and then, in step S104, is transferred to a processing apparatus 10b as illustrated in Part (a) of Fig. 2.

As illustrated in Part (b) of Fig. 2, the epitaxial substrate E is then heated in the processing apparatus 10b in step S105. In a typical heating condition, the heating temperature is for example 750 degrees Celsius, the thermal-processing time is 30 minutes, and the thermal-processing atmosphere is for example a Ga atmosphere. The thermal-processing temperature may be, for example, 300 degrees Celsius or higher, because gallium oxide Ga₂O₃ cannot be reduced to form Ga₂O, which has a higher vapor pressure, at a temperature lower than 300 degrees Celsius. The annealing temperature may also be, for example, 900 degrees Celsius or lower to prevent the active layer 17 from being damaged. The annealing atmosphere may be, for example, a Ga atmosphere.

After the thermal-processing of the epitaxial substrate E, in step S106, as illustrated in Part (c) of Fig. 2, an atmosphere containing gallium is formed in a chamber of the processing apparatus 10b without breaking the vacuum in the chamber of the processing apparatus 10b and then the surface 13a of the epitaxial substrate E is exposed to the atmosphere. The atmosphere in this step preferably contains no nitrogen to avoid growth of a gallium nitride based semiconductor. The substrate temperature in the step may be, for example, 300 degrees Celsius or higher, such that digallium trioxide, Ga₂O₃, cannot be reduced to Ga₂O, which has a higher vapor pressure, at a temperature lower than 300 degrees Celsius. The substrate temperature may also be, for example, 900 degrees Celsius or lower to prevent the deterioration of the active layer 17. The heating time is, for example, 30 minutes.

The substrate temperature during the thermal treatment step and the exposing step is preferably equal to or lower than the lowest temperature during the growth of the epitaxial substrate E to reduce heat stress, which may be possibly caused by the modification in the thermal treatment step and the exposing step, to the active layer. Provided that the active layer includes an InGaN layer, the substrate temperature of the epitaxial substrate E is preferably equal to or lower than the growth temperature of, for example, the InGaN well layers of the active layer, which can avoid thermal deterioration in the quality of the InGaN layer of the active layer in the thermal treatment step and the exposing step.

According to an embodiment of the fabrication step, placing the surface 13a of the epitaxial substrate E in the gallium atmosphere is carried out by applying gallium fluxes 31 to the surface 13a.

Gallium oxide has a wide variety of compounds. The resulting gallium oxides have different melting points. The difference in melting point enables the decrease in the oxygen concentration of the semipolar primary surface. The gallium oxide formed thereat includes, for example, Ga₂O₃ having a relatively high melting point (for example, 1725 degrees Celsius, under one atmospheric pressure at room temperature), and Ga₂O having a relatively low melting point (for example, 500 degrees Celsius, 1 × 10⁻⁶ Torr).

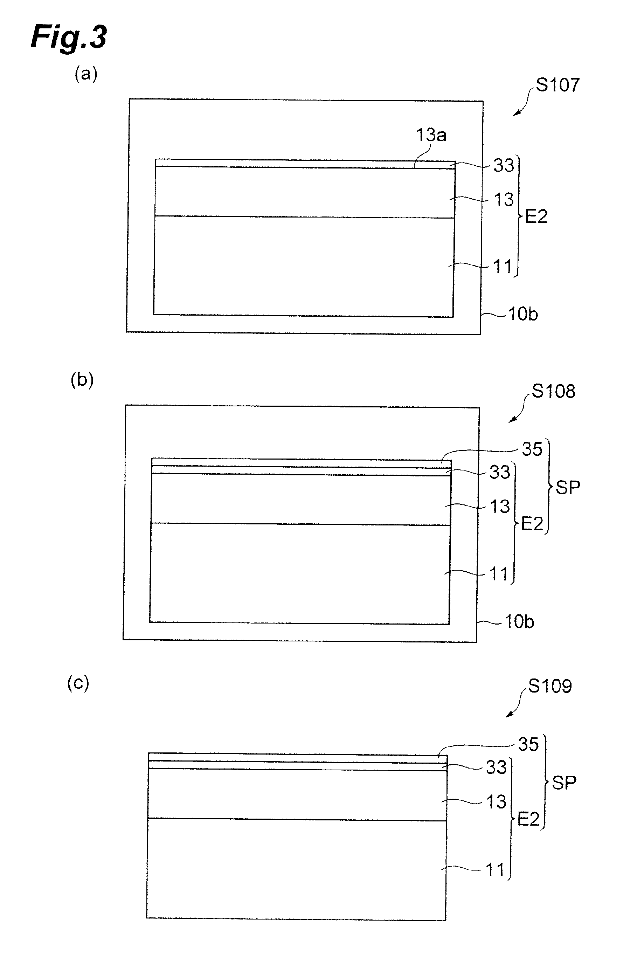

In the steps described above, the epitaxial substrate E is disposed in the vacuum chamber of the processing apparatus 10b and is then modified by annealing and irradiation with Ga. After these steps, in step S107, a gallium nitride based semiconductor layer 33 may be grown on the semiconductor laminate 13, which includes the active layer 17, without breaking the vacuum of the chamber of the processing apparatus 10b to provide a new epitaxial substrate E2 in the vacuum chamber of the processing apparatus 10b as illustrated in Part (a) of Fig. 3. The method may reduce the oxygen concentration of the group III nitride semiconductor produced in this growth step.

The gallium nitride based semiconductor layer 33 is preferably doped with a dopant providing desired conductivity, for example, a p-type dopant such as magnesium or zinc for the following step in which a metal layer for an electrode is grown on the gallium nitride based semiconductor layer 33. The concentration of the p-type dopant may be ranging, for example, from 1×10¹⁶cm⁻³ to 1×10²¹cm⁻³. The production method can provide an electrode exhibiting ohmic contact to the p-type gallium nitride based semiconductor layer.

After the removal of the gallium atmosphere, as illustrated in Part (b) of Fig. 3, a conductive layer 35 for an electrode is grown on the primary surface of the epitaxial substrate E2 in the chamber of the processing apparatus 10b without breaking vacuum, to form a substrate product SP in step S107.

According to the production method, the epitaxial substrate E is exposed to the atmosphere containing gallium at a substrate temperature of 300 degrees Celsius or higher in the vacuum chamber of the processing apparatus 10b without growing a group III nitride semiconductor. The surface of the group III nitride semiconductor of the epitaxial substrate E is covered with digallium trioxide Ga₂O₃ before the exposing step. In the exposing step, gallium is supplied to the semipolar primary surface 13a of the gallium nitride based semiconductor to transform digallium trioxide Ga₂O₃ on the semipolar primary surface into digallium oxide Ga₂O, which has a low melting point. Digallium oxide Ga₂O is released from the surface of the gallium nitride based semiconductor into the vacuum chamber of the reactor 10a by the action of the substrate temperature in the exposing step, depending on its melting point. In other words, irradiation of the semipolar primary surface 13a with Ga fluxes, which the surface is readily oxidized with oxygen, can decrease the oxygen concentration around the semipolar primary surface 13a before the electrode layer forms a junction with the semipolar primary surface. Accordingly, the resulting group III nitride semiconductor light emitting device has satisfactory ohmic contact.

In the embodiment, after exposing the epitaxial substrate E to the gallium atmosphere, the metal film formation, such as a conductive layer 35, may be carried out without growth of the group III nitride semiconductor. The method can provide an ohmic electrode on the semipolar surface 13a that has been modified.

The conductive layer 35 preferably comprises any one of Au, Pd, Ni, Rh, Al, Ti, Zn, Cu, In, Ta, Pt, and Tl. According to the production method, the conductive layer 35 preferably contains at least one of Au, Pd, Ni, Rh, Al, Ti, Zn, Cu, In, Ta, Pt, and Tl.

As illustrated in Part (c) of Fig.3, the epitaxial substrate E2 is taken out of the processing apparatus 10b in step S109, so that the epitaxial substrate E2 is exposed to the atmosphere containing oxygen. Since the semipolar surface composed of a gallium nitride based semiconductor has been already covered with the conductive layer 35, the metal layer at the top of the substrate product SP is exposed thereto. As illustrated in Part (c) of Fig. 3, the substrate product SP taken out of the processing apparatus 10b is placed in an atmosphere containing oxygen.

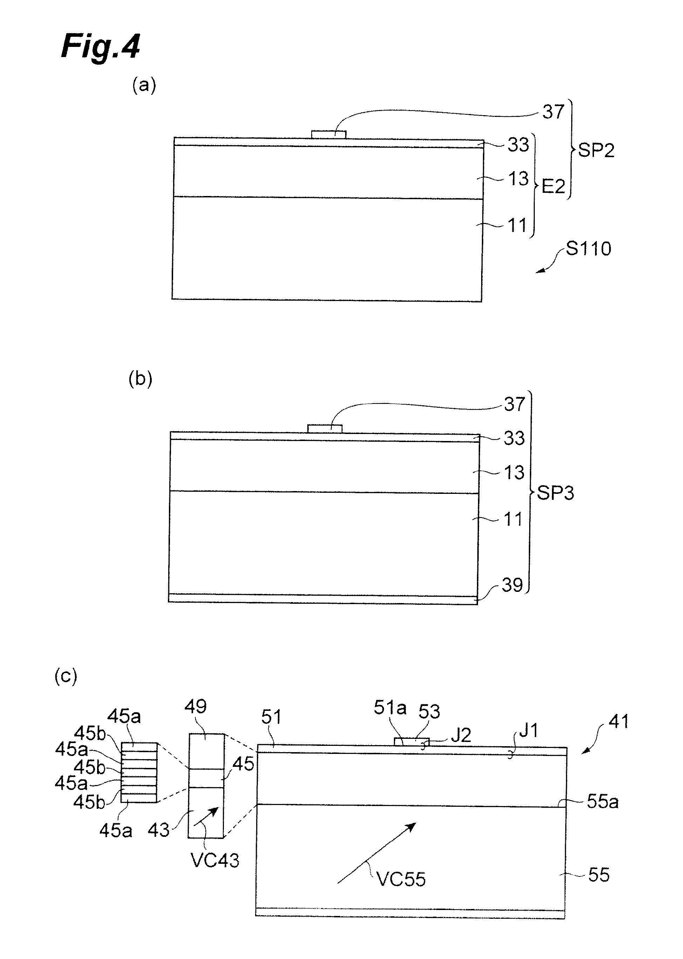

After the substrate product SP is taken out of the vacuum chamber of the processing apparatus 10b, the conductive layer 35 is patterned to form an electrode 37 in step S110 as illustrated in Part (a) of Fig. 4. The method does not include alloying of the electrode 37 after growing the conductive layer 35. Advantageously, the non-alloy electrode 37 barely undergoes thermal deterioration of the electrode and the interface between the electrode and the semiconductor.

An electrode 39 is formed on the back surface 11b of the substrate 11 in step S111 as illustrated in Part (b) of Fig. 4. Before forming the electrode 39, the back surface of the substrate 11 is polished into a desired thickness to provide the polished back surface. A substrate product SP3 is produced through these steps.

After these steps, the substrate product SP3 is separated to form a group III nitride semiconductor light emitting device 41. The group III nitride semiconductor light emitting device 41 includes a group III nitride semiconductor layer 43 of a first conductivity type, an active layer 45 disposed on the primary surface of the group III nitride semiconductor layer 43 of a first conductivity type, a first group III nitride semiconductor layer 49 disposed on the primary surface of the active layer 45, a second group III nitride semiconductor layer 51 disposed on the primary surface of the first group III nitride semiconductor layer 49, and an electrode 53 disposed on the primary surface of the second group III nitride semiconductor layer 51. The second group III nitride semiconductor layer 51 forms a first junction J1 with the first group III nitride semiconductor layer 49. The electrode 53 forms a second junction J2 with the second group III nitride semiconductor layer 51.

The first and the second junctions J1 and J2 tilt from the reference plane orthogonal to the c-axis VC43 of the first conductivity type group III nitride semiconductor layer 43. The primary surface of the active layer 45 tilts with respect to the reference plane, which is orthogonal to the c-axis VC43 of the first conductivity type group III nitride semiconductor layer 43. Well layers 45b and barrier layers 45a constituting the active layer 45 extend along the plane tilting from the reference plane that is orthogonal to the c-axis VC43 of the first conductivity type group III nitride semiconductor layer 43. The first and second group III nitride semiconductor layers 49 and 51 have a second conductivity type.

In the group III nitride semiconductor light emitting device 41, since the second junction J2 tilts with respect to the reference plane that is orthogonal to the c-axis VC43, the electrode 53 forms a junction with the semipolar surface of the second group III nitride semiconductor layer 51. The second junction J2 between the electrode 53 and the semipolar surface 51a exhibits satisfactory ohmic characteristics.

The first and second junctions J1 and J2 are substantially parallel to the primary surface 55a, and preferably tilt at an angle ranging from 10 degrees to 80 degrees.

The group III nitride semiconductor light emitting device 41 may further include a support base 55, the support base 55 having the primary surface 55a composed of the group III nitride semiconductor. The primary surface 55a of the support base 55 tilts at an angle in the range of 10 degrees to 80 degrees with respect to the plane that is orthogonal to the reference axis extending along the c-axis VC55 of the group III nitride semiconductor. The group III nitride semiconductor layer 43, the active layer 45, the first group III nitride semiconductor layer 49, and the second group III nitride semiconductor layer 51 are arranged along the normal Nx to the primary surface 55a of the support base 55.

The primary surface 55a of the support base 55 preferably tilts at an angle in the range of 63 degrees to 80 degrees with respect to the plane that is orthogonal to the reference axis extending along the c-axis of the group III nitride semiconductor. The semipolar surface tilting in the above angle range has steps which are readily oxidized.

The oxygen concentration of the second group III nitride semiconductor layer 51 is preferably 1 × 10¹⁸cm⁻³ or lower to provide satisfactory ohmic characteristics.

The active layer 45 includes a gallium nitride based semiconductor layer containing indium as a group III constituent element, and is configured to provide a peak emission wavelength within a wavelength range of, for example, 500 nm to 540 nm.

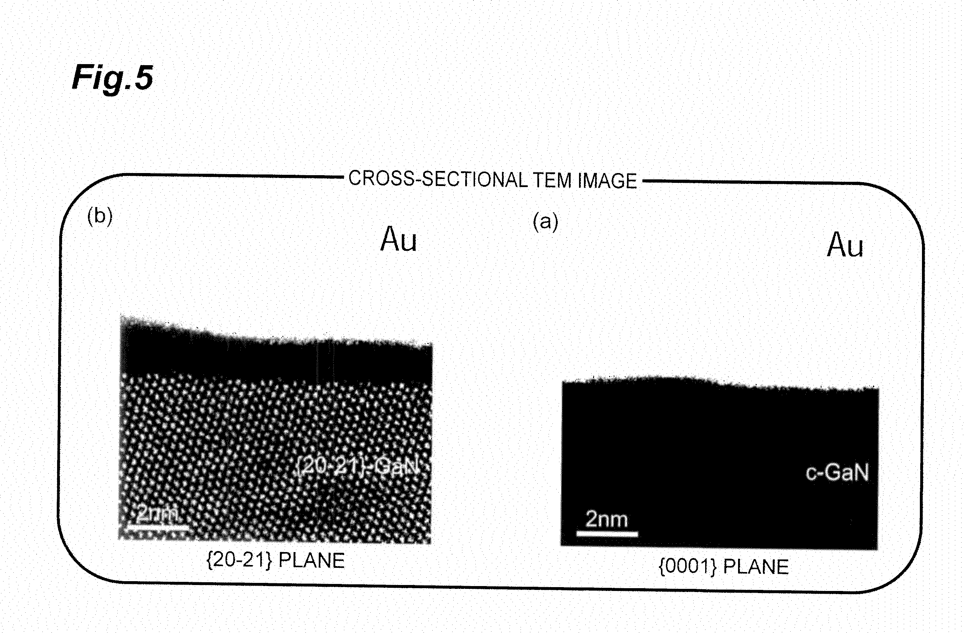

Fig. 5 is a transmission electron microscopic (TEM) image around the interface between a GaN region and an electrode (metal). Part (a) of Fig. 5 shows a junction between the gold (Au) layer and the c-plane. Part (b) of Fig. 5 shows a junction between the gold layer and a {20-21} plane. In Part (b) of Fig. 5, a layer shown darkly is observed at the interface between the gold (Au) layer and a {20-21}-GaN layer. This dark layer is thicker than that at the interface shown in Part (b) of Fig. 5 in thickness. The dark layers indicate interfacial oxide. Fig. 5 demonstrates that the oxide layer on the semipolar surface is thicker than that on the c-plane.

### (Example 1)

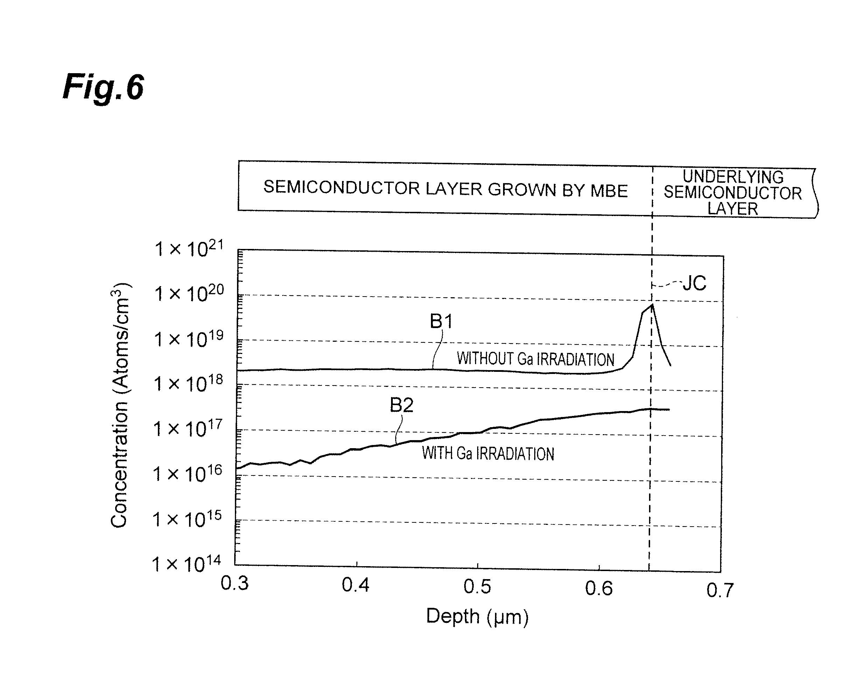

Fig. 6 is a graph representing the oxygen concentration in a gallium nitride based semiconductor region as a base layer for an electrode, and shows the oxygen concentration measured by secondary ion mass spectroscopic (SIMS) analysis. For evaluation of the SIMS analysis, the following device structure is prepared. The following layers are grown in sequence over the {20-21} GaN substrate, and in the graph, the depth of the resulting layers increases from left to right on the horizontal axis (from 0.3 µm to 0.7 µm deep):
ud-GaN: 630 nm;
p-GaN: 50 nm;
p-GaN: 400 nm;
n-GaN: 1000 nm.
An epitaxial substrate indicated by a dashed line JC in Fig. 6 is prepared. The epitaxial substrate includes the {20-21} GaN substrate, an n-type GaN layer (1000 nm), a p-type GaN layer (400 nm), and a p-type GaN layer (50 nm). The n-type GaN layer (1000 nm), the p-type GaN layer (400 nm), and the p-type GaN layer (50 nm) are grown over the {20-21} GaN substrate. The surface of the p-type GaN layer (50 nm) is exposed to air, which contains oxygen. Epitaxial substrates A1 and A2 each having the above-described structure are prepared. The epitaxial substrate A1 is set in a molecular beam epitaxy (MBE) system, and an undoped GaN layer (630 nm) is grown on the p-type GaN layer (50 nm) by MBE without applying Ga fluxes to provide an epitaxial substrate B 1. The epitaxial substrate A2 is irradiated with Ga fluxes in the molecular beam epitaxy (MBE) system and then an undoped GaN layer (630 nm) is grown on the p-type GaN layer (50 nm) by MBE to form an epitaxial substrate B2.

The condition of the gallium irradiation is as follows:
Substrate temperature: 750 degrees Celsius;
Density of Ga fluxes: 1.4×10⁻⁶ Torr (1 Torr corresponding to 133.322 Pa.);
Irradiation time: 30 minutes.

Referring to Fig. 6, measurement result B1 from the observation of the surface which has not been irradiated with Ga fluxes shows an oxygen peak (which has a peak value above 1×10¹⁹cm⁻³ and around 1×10²⁰cm⁻³) and a flat level of the oxygen concentration (stationary value greater than 1×10¹⁸cm⁻³) in the GaN layer grown by MBE, which are measured by SIMS analysis.

Referring to Fig. 6, measurement result B2 from the observation of the surface which has been irradiated with Ga fluxes shows that the oxygen concentration profile does not exhibit any oxygen peaks, and the oxygen peak like one observed in measurement result B1(a peak value above 1× 10¹⁹ cm⁻³ and around 1 × 10²⁰cm⁻³) is not observed.

Fig. 6 demonstrates that Ga flux irradiation can reduce the amount of gallium oxides formed through the exposure to the atmosphere containing oxygen. Since a conductive layer for an electrode may be grown after the Ga flux irradiation over the semipolar surface including gallium oxides, the conductive layer for an electrode can be grown on the semipolar surface having a decreased oxygen concentration. A gallium nitride based semiconductor layer may be grown after the Ga flux irradiation to decrease the oxygen concentration of the semiconductor layer, and then the conductive layer for an electrode may be grown on the semipolar surface of the gallium nitride based semiconductor layer having a decreased oxygen concentration.

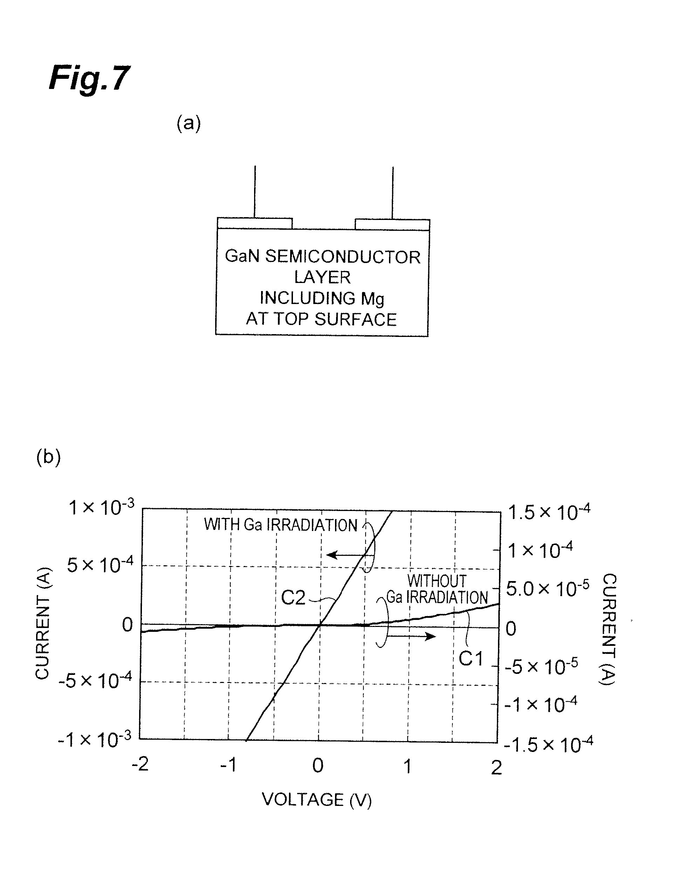

Fig. 7 is a diagram representing current-voltage characteristics. Part (a) of Fig. 7 illustrates a device structure, which is measured. An epitaxial substrate includes a {20-21} GaN substrate, a n-type GaN layer (1000 nm), a p-type GaN layer (400 nm), a first p-type GaN layer (50 nm), and a second p-type GaN layer (50 nm). The n-type GaN layer (1000 nm), the p-type GaN layer (400 nm), the first p-type GaN layer (50 nm), and the second p-type GaN layer (50 nm) are grown over the {20-21} GaN substrate. The surface of the first p-type GaN layer (50 nm) is exposed to an atmosphere containing oxygen. The second p-type GaN layer (50 nm) is grown on the surface of the first p-type GaN layer (50 nm) without applying Ga fluxes with an MBE system, and a gold electrode is formed on the second p-type GaN layer (50 nm) to provide a substrate product C1. The second p-type GaN layer (50 nm) is grown on the first p-type GaN layer (50 nm) in the MBE system and is irradiated with Ga flux, and then a gold electrode is formed on the second p-type GaN layer (50 nm) to provide a substrate product C2. The substrate products C1 and C2 each having a structure which includes the gold electrode having a thickness of 2000 nm are prepared.

Part (b) of Fig. 7 demonstrates that Ga flux irradiation leads to satisfactory ohmic characteristics and reduction in drive voltage. According to the embodiment, a contact resistance is 1×10⁻³Ω·cm² or lower. Gold has low reactivity, and this electrode is preferably used for an examination for the action of an oxide layer. Materials for the electrode, however, are not limited to gold.

The oxygen profile at the interface between the electrode and the gallium nitride based semiconductor depends on the Ga irradiation. Specifically, the Ga irradiation decreases the thickness of the oxide layer at the interface between the electrode and the semiconductor layer. Various experiments other than that disclosed in the specification have been conducted. These experiments demonstrate that the oxygen concentration at the interface between metal and semiconductor is at least ten times the oxygen concentration in the gallium nitride based semiconductor layer (100 nm deep from the interface) forming a junction with the metal. The kind of the semiconductor layer is not changed.

### (Example 2)

The inventors have estimated the relation between a degree of vacuum and a substrate temperature during Ga irradiation by a simulation. The simulation is conducted with HSC Chemistry which is software for calculation of chemical reaction/equilibrium manufactured by Outotec Research Oy. The results of the estimation are shown below:
Ambient Pressure, Annealing Temperature (degrees Celsius)
7.50E-02, 1070 degrees Celsius or higher,
7.50E-03, 860 degrees Celsius or higher,
7.50E-04, 710 degrees Celsius or higher,
7.50E-05, 610 degrees Celsius or higher,
7.50E-06, 540 degrees Celsius or higher,
7.50E-07, 490 degrees Celsius or higher,
7.50E-08, 450 degrees Celsius or higher,
7.50E-09, 400 degrees Celsius or higher,
7.50E-10, 370 degrees Celsius or higher,
7.50E-11, 340 degrees Celsius or higher,
7.50E-12, 310 degrees Celsius or higher,
7.50E-13, 290 degrees Celsius or higher.
The representation "7.50E-13" refers to "7.50×10⁻¹³." This estimation shows that the substrate temperature may become low as the degree of vacuum during the Ga irradiation decreases (high vacuum).

Having described and illustrated the principle of the invention in a preferred embodiment thereof, it is appreciated by those having skill in the art that the invention can be modified in arrangement and detail without departing from such principles. We therefore claim all modifications and variations coming within the spirit and scope of the following claims.

### [Industrial Applicability]

As described above, the embodiments provide a method for producing a group III nitride semiconductor light emitting device having a satisfactory ohmic contact. The embodiments also provide a group III nitride semiconductor light emitting device having a satisfactory ohmic contact.

**[Reference Signs List]**

| | |
|---|---|
| 10a | reactor; |
| 10b | processing apparatus; |
| 11 | substrate; |
| 12 | native gallium oxide; |
| 13 | semiconductor stack; |
| 13a | surface of semiconductor stack; |
| E, E2 | epitaxial substrate; |
| 15 | n-type group III nitride semiconductor region; |
| 17 | active layer; |
| 19 | p-type group III nitride semiconductor region; |
| 21 | quantum well structure, |
| 23 | barrier layer, |
| 25 | well layer, |
| 27 | electron blocking layer; |
| 29 | p-type cladding layer; |
| 31 | gallium flux; |
| 33 | gallium nitride based semiconductor layer; |
| 35 | conductive layer; |
| SP3 | substrate product; |
| 41 | group III nitride semiconductor light emitting device; |
| 43 | first conductivity type group III nitride semiconductor layer; |
| 45 | first conductivity type group III nitride semiconductor layer; |
| 47 | active layer; |
| 49 | first group III nitride semiconductor layer; |
| 51 | second group III nitride semiconductor layer; |
| 53 | electrode; |
| J1, J2 | junction; |
| 55 | support base. |

## Claims

1. A method for fabricating a group III nitride semiconductor light emitting device comprising the steps of:
placing an epitaxial substrate in a gallium atmosphere in a vacuum chamber at a substrate temperature of 300 degrees Celsius or higher without growing a group III nitride semiconductor; and
growing a conductive film for an electrode on a primary surface of the epitaxial substrate in the vacuum chamber to form a substrate product,
the primary surface of the epitaxial substrate having semi-polarity of a gallium nitride based semiconductor, and
the epitaxial substrate including an active layer, the active layer comprising a group III nitride semiconductor.

2. The method for fabricating a group III nitride semiconductor light emitting device according to Claim 1, the method further comprising the step of growing a semiconductor region on the primary surface of the substrate to form the epitaxial substrate,
the primary surface of the substrate comprising a group III nitride semiconductor,
the semiconductor region including a first conductivity type group III nitride semiconductor layer, the active layer, and a second conductivity type group III nitride semiconductor layer,
the epitaxial substrate including the substrate,
the primary surface of the substrate tilting at an angle in a range of 10 degrees to 80 degrees with respect to a plane orthogonal to a reference axis, the reference axis extending along a c-axis of the group III nitride semiconductor, and
the primary surface of the epitaxial substrate tilting at an angle in a range of 10 degrees to 80 degrees with respect to a plane orthogonal to a reference axis, the reference axis extending along a c-axis of the group III nitride semiconductor.

3. The method for fabricating a group III nitride semiconductor light emitting device according to Claim 1 or 2, wherein
the epitaxial substrate includes a p-type gallium nitride based semiconductor layer on the active layer,
the p-type gallium nitride based semiconductor layer comprises magnesium as a dopant, and
a primary surface of the p-type gallium nitride based semiconductor layer constitutes the primary surface of the epitaxial substrate.

4. The method for fabricating a group III nitride semiconductor light emitting device according to any one of Claims 1 to 3, wherein the conductive layer comprises any one of Au, Pd, Ni, Rh, Al, Ti, Zn, Cu, In, Ta, Pt, and Tl.

5. The method for fabricating a group III nitride semiconductor light emitting device according to any one of Claims 1 to 4, wherein the substrate temperature is equal to or lower than the lowest temperature used in during the growth of the epitaxial substrate.

6. The method for fabricating a group III nitride semiconductor light emitting device according to any one of Claims 1 to 5, wherein the substrate temperature is not more than 900 degrees Celsius.

7. The method for fabricating a group III nitride semiconductor light emitting device according to any one of Claims 1 to 6, wherein the active layer includes an InGaN layer, and
the substrate temperature of the epitaxial substrate is equal to or lower than a growth temperature of the InGaN layer of the active layer.

8. The method for fabricating a group III nitride semiconductor light emitting device according to any one of Claims 1 to 7, the method further comprising the step of carrying out patterning of the substrate product to form the electrode after the substrate product is removed from the vacuum chamber,
wherein the method does not include alloying of the electrode after the growth of the conductive film.

9. The method for fabricating a group III nitride semiconductor light emitting device according to any one of Claims 1 to 8, wherein
the group III nitride semiconductor of the substrate comprises GaN, and
the primary surface of the epitaxial substrate comprises GaN.

10. The method for fabricating a group III nitride semiconductor light emitting device according to any one of Claims 1 to 9,
wherein the primary surface of the epitaxial substrate tilts at an angle in a range of 63 degrees to 80 degrees away from the plane orthogonal to a reference axis and the reference axis extends along a c-axis of the group III nitride semiconductor.

11. The method for fabricating a group III nitride semiconductor light emitting device according to any one of Claims 1 to 10, wherein the conductive film is grown on the epitaxial substrate without growing any group III nitride semiconductor after the epitaxial substrate is exposed to the gallium atmosphere.

12. The method for fabricating a group III nitride semiconductor light emitting device according to any one of Claims 1 to 11, the method further comprising the step of:
growing a gallium nitride based semiconductor on the active layer of the epitaxial substrate after the epitaxial substrate is exposed to the gallium atmosphere, in the vacuum chamber.

13. The method for fabricating a group III nitride semiconductor light emitting device according to any one of Claims 1 to 11, wherein an oxygen concentration of the gallium nitride based semiconductor layer in contact with the conductive film is 1×10¹⁸ m⁻³ or lower.

14. A group III nitride semiconductor light emitting device comprising:
a first conductivity type group III nitride semiconductor layer;
an active layer provided on a primary surface of the first conductivity type group III nitride semiconductor layer;
a group III nitride semiconductor layer provided on the primary surface of the active layer; and
an electrode forming a junction with the group III nitride semiconductor,
the group III nitride semiconductor layer being of a second conductivity type, and
the junction tilting away from a reference plane orthogonal to a c-axis of the first conductivity type group III nitride semiconductor layer.

15. The group III nitride semiconductor light emitting device according to Claim 14,
wherein the junction tilts at an angle in a range of 10 degrees to 80 degrees with respect to a plane orthogonal to a reference axis extending along the c-axis.

16. The group III nitride semiconductor light emitting device according to Claim 14 or 15, wherein the electrode comprises any one of Au, Pd, Ni, Rh, Al, Ti, Zn, Cu, In, Ta, Pt, and Tl.

17. The group III nitride semiconductor light emitting device according to any one of Claims 14 to 16, further comprising a support base, the support base comprising a group III nitride semiconductor,
wherein the primary surface of the support base tilts at an angle in a range of 10 degrees to 80 degrees with respect to a plane orthogonal to a reference axis extending along a c-axis of the group III nitride semiconductor, and
the first conductivity type group III nitride semiconductor layer, the active layer, and the group III nitride semiconductor layer are arranged along a normal to the primary surface of the support base.

18. The group III nitride semiconductor light emitting device according to any one of Claims 14 to 17, wherein
the group III nitride semiconductor of the support base comprises GaN, and
the primary surface of the group III nitride semiconductor layer comprises GaN.

19. The group III nitride semiconductor light emitting device according to any one of Claims 14 to 18, wherein an oxygen concentration of the group III nitride semiconductor layer is 1 × 10¹⁸ cm⁻³ or lower.

20. The group III nitride semiconductor light emitting device according to any one of Claims 14 to 19, wherein the active layer comprises a gallium nitride based semiconductor containing indium as a group III constituent element.
